# EUROPÄISCHE PATENTSCHRIFT

(11) **EP 2 173 618 B1**
(45) Veröffentlichungstag und Bekanntmachung des Hinweises auf die Patenterteilung: **22.06.2011**
(21) Anmeldenummer: 08760223.1
(22) Anmeldetag: 29.05.2008
(51) Int. Cl.: B64G 1/10, B64G 1/64, H03K 17/955

(54) **ROBUSTER KAPAZITIVER ABSTANDSSENSOR**
ROBUST CAPACITIVE DISTANCE SENSOR
DÉTECTEUR DE DISTANCE CAPACITIF ROBUSTE

(30) Priorität: 06.07.2007 DE 102007031547
(43) Veröffentlichungstag der Anmeldung: 14.04.2010
(73) Patentinhaber: Deutsches Zentrum für Luft- und Raumfahrt e.V., 51147 Köln (DE)
(72) Erfinder: GRUBER, Robin, 81371 München (DE); BAUMANN, Andreas, 92521 Schwarzenfeld (DE)
(74) Vertreter: von Kreisler Selting Werner
(86) Internationale Anmeldenummer: PCT/EP2008/056632
(87) Internationale Veröffentlichungsnummer: WO 2009/007176

(56) Entgegenhaltungen:
- WO-A-2004/054105
- DE-A1- 4 213 926
- GB-A- 2 296 972
- US-A- 3 555 534
- US-A1- 2005 040 282
- US-B1- 6 969 030

## Beschreibung

Die Erfindung betrifft eine Andockvorrichtung zum Andocken einer Wartungsvorrichtung an einen Satelliten, siehe z.B US 6 969 030 und US 2005/0040282.

Beim Betrieb von Satellitensystemen wird derzeit so verfahren, dass Satelliten, deren Tank für die Lageregelung erschöpft ist, still gelegt werden müssen. Weiterhin können defekte Satelliten weder repariert noch korrekt entsorgt werden. Um eine Wartung der Satelliten zu ermöglichen, werden sogenannte "On Orbit Servicing"-Konzepte entwickelt, im Rahmen derer mit Hilfe von speziellen Servicesatelliten (sogenannten Robonauten) Wartungsarbeiten an defekten Satellitensystemen durchgeführt werden können.

Um eine Wartung jedweder Form, beispielsweise durch eine oben beschriebene Wartungsvorrichtung durchführen zu können, muss zunächst ein Andocken der Wartungsvorrichtung an den zu wartenden Satelliten erfolgen. Heutige Satelliten sind dafür allerdings nicht ausgelegt, da sie keinerlei standardisierte Griffe oder Haken besitzen, die einen stabilen Kontakt zur Wartungsvorrichtung ermöglichen. Dies führt dazu, dass nicht mehr funktionsfähige Satelliten überhaupt nicht gewartet werden können und somit still gelegt werden müssen.

Aufgabe der Erfindung ist es, eine Vorrichtung zu schaffen, die ein Warten eines Satelliten ermöglicht.

Die Aufgabe wird erfindungsgemäß gelöst durch die Merkmale des Anspruchs 1.

Es ist eine Andockvorrichtung zum Andocken einer Wartungsvorrichtung an eine Düse eines Satelliten vorgesehen. Bei der Düse des Satelliten kann es sich beispielsweise um den Apogäumsmotor handeln, d.h. dem Raketenmotor, der den Satelliten in seine geostationäre Umlaufbahn bringt und später nicht mehr verwendet wird.

Erfindungsgemäß ist zum Verbinden der Andockvorrichtung mit der Düse des Satelliten eine Verriegelungsvorrichtung vorgesehen. Als Verriegelungsvorrichtung wird in diesem Zusammenhang eine Vorrichtung verstanden, durch die eine feste mechanische Verbindung zwischen der Andockvorrichtung und der Düse des Satelliten erfolgt.

Ein zu frühes oder zu spätes Verriegeln der Verriegelungsvorrichtung kann dazu führen, dass die Düse des Satelliten nicht korrekt gegriffen wird und somit ein Andocken erschwert oder verhindert wird. Daher ist erfindungsgemäß weiterhin ein Abstandssensor zum Bestimmen des Abstandes zwischen der Wartungsvorrichtung und der Düse des Satelliten vorgesehen.

Durch die Verwendung einer Andockvorrichtung zum Andocken der Wartungsvorrichtung an eine Düse des Satelliten kann auch ein Andocken der Wartungsvorrichtung an Satelliten erfolgen, die über keine speziellen Griffe oder Haken verfügen, die einen stabilen Kontakt zu der Wartungsvorrichtung ermöglichen. Insbesondere handelt es sich bei der Düse des Satelliten um eine Komponente, über die jeder Satellit verfügt, so dass die erfindungsgemäße Andockvorrichtung zum Andocken an viele Arten von Satelliten geeignet ist.
Der Abstandssensor ist als Kapazitiver Abstandssensor ausgebildet, wobei der kapazitive Abstandssensor mehrere, insbesondere drei kapazitive Sensormodule aufweisen kann. Diese können insbesondere in gleichmäßigen Abständen an der Außenseite einer ringförmigen Haltevorrichtung angebracht sein. Die Haltevorrichtung kann insbesondere kreisringförmig ausgebildet sein, wobei vorzugsweise drei kapazitive Sensormodule vorgesehen sind, die an der Außenseite der ringförmigen Haltevorrichtung um 120° versetzt angebracht sind.

In einer bevorzugten Ausführungsform ist die ringförmige Haltevorrichtung als ringförmiger Kegelstumpf ausgebildet. Dabei können die Sensormodule an der Außenseite der Mantelfläche des ringförmigen Kegelstumpfes, insbesondere in einem spitzen Winkel zur Grundfläche des Kegelstumpfes, angeordnet sein.

Die im Weltraum herrschenden Umgebungsbedingungen stellen an Sensoren deutlich höhere Anforderungen als dies bei terrestrischen Applikationen der Fall ist. Zu berücksichtigen sind beispielsweise große Temperaturschwankungen, eine hohe Strahlendosis und zumindest bei Kontakt zwischen zwei im Orbit befindlichen Satelliten eine Gefährdung durch stark unterschiedliche Spannungspotentiale.

Um diesen widrigen Umweltbedingungen zu begegnen, kann der kapazitive Abstandssensor wie im folgenden beschrieben aufgebaut sein.

Der kapazitive Abstandssensor kann einen Oszillator aufweisen, wobei der Oszillator ein kapazitives Sensormodul und eine Induktivität aufweist, die zu einem elektrischen Schwingkreis verschaltet sind. Um eine Dämpfung des elektrischen Schwingkreises zu vermeiden, ist weiterhin eine Energiezuführvorrichtung, beispielsweise in Form eines Transistors, vorgesehen, durch die dem elektrischen Schwingkreis elektrische Energie zugeführt wird.

Bevorzugt weist die Induktivität eine Primärwicklung und eine Sekundärwicklung auf, wobei die Primärwicklung und die Sekundärwicklung galvanisch getrennt sind. Das kapazitive Sensormodul ist somit über die Primärwicklung und die Sekundärwicklung transformatorisch in den Oszillator eingebunden. Die Sekundärwicklung ist elektrisch mit dem kapazitiven Sensormodul verbunden. Elektrische Entladungen, die beim Kontakt des Sensormoduls mit einem elektrisch geladenen Objekt entstehen können, werden somit von dieser Isolationsbarriere und gegebenenfalls einer Schirmwicklung des Kerns zurückgehalten. Die Schirmwicklung hält eine durch eine elektrostatische Entladung entstehende Gleichtaktstörung durch Ableitung nach Masse oder auf das Gehäuse zurück.

Weiterhin kann durch den beschriebenen Aufbau das kapazitive Sensormodul mit einer deutlich höheren Spannung betrieben werden als die Oszillatorschaltung, wenn die Sekundärwicklung mehr Windungen aufweist als die Primärwicklung. Dies vereinfacht zum einen die Verwendung von kapazitätsarmen Hochfrequenztransistoren, die damit nur einen kleinen Anteil an der Gesamtkapazität des Schwingkreises haben und so die Empfindlichkeit nur wenig beeinflussen. Zum anderen wird durch das Übersetzungsverhältnis des Transformators die für die Oszillatorschaltung effektive Kapazität des Sensors vergrößert, so dass auch ein Sensorelement mit nur wenigen Picofarad messbar bleibt und nicht klein gegenüber möglichen parasitären Kapazitäten der Oszillatorschaltung wird.

Ein weiterer Vorteil eines derartigen Aufbaus ist, dass die Kondensatorplatten des Sensormoduls sehr symmetrisch angesteuert werden, so dass nur eine geringe Aussendung von Störstrahlung aufgrund von Gleichtaktstörungen erfolgt. Das Feld von zwei exakt gegenphasig angesteuerten Kondensatorplatten hebt sich im Fernfeld auf, solange die Frequenz gering gegenüber den Abmessungen der Platten ist. Andernfalls funktionieren diese als Dipol und strahlen eine elektromagnetische Welle ab, was nicht gewünscht wäre. Falls die Ansteuerung der Platten jedoch einen Gleichtaktanteil aufweist, also eine (Wechsel-) Spannungsdifferenz zwischen der mittleren Spannung der Kondensatorplatten und dem Gehäuse der Anordnung besteht, wirkt das Gehäuse der Anordnung als ein Pol eines Dipols und die beiden Kondensatorplatten als der andere. So kommt es bei gleicher Betriebsfrequenz allein durch die größeren beteiligten Geometrien zu einer stärkeren Abstrahlung elektromagnetischer Wellen.

Zur Optimierung der Symmetrierung kann weiterhin die Sekundärseite der Induktivität einen Mittelabgriff aufweisen, der mit einer Gehäusemasse verbunden werden kann. Ohne Mittelabgriff in der Sekundärwicklung kann eine Asymmetrie in der parasitären Kapazität der Kondensatorplatten gegenüber dem Gehäuse zu Asymmetrien in der Kondensatorplattenspannung führen, die dann wieder eine erhöhte Störabstrahlung durch das Gleichtaktproblem erzeugt. Wird der Mittelabgriff auf das Gehäuse gelegt, so ist durch die transformatorische Kopplung über die jeweils gleiche Anzahl Windungen sichergestellt, dass eine Kondensatorplatte genau die gegenphasige Spannung mit exakt gleicher Amplitude wie die andere Platte bezogen auf das Gehäuse aufweist.

Besonders bevorzugt ist der Oszillator als Hartley-Oszillator ausgebildet.

In einer bevorzugten Ausführungsform weist der Oszillator eine Kapazitätsdiode zur Abstimmung des Oszillators auf. Dabei ist dem Oszillator über die Kapazitätsdiode eine temperaturabhängige Spannung zuführbar, so dass eine zusätzliche Verstimmung des Oszillators erreicht werden kann, um damit einen Temperaturdrift zu kompensieren. Anstatt parallel zu einem für die Hartley-Oszillator-Schaltung ohnehin vorhandenen Abgriffen an der Spule zu nutzen, kann auch eine zusätzliche eigene Wicklung für die Verstimmung auf den Kern aufbringen. Zur Verstimmung eines Schwingkreises werden häufig Kapazitätsdioden eingesetzt. Diese werden meistens noch über einen weiteren Kondensator zur Abtrennung der Gleichspannung, welche zur Verstimmung genutzt wird, vom Schwingkreis parallel zum Schwingkreiskondensator geschaltet. Die Bezugsspannung wird dabei von Schaltungstopologie des Oszillators bestimmt und ist nicht immer optimal für die Zuführung der Steuerspannung.

Durch die gute magnetische Kopplung der Windungen in der hier verwendeten Spule spielt es aber keine Rolle, ob eine zusätzliche Kapazität für die Verstimmung direkt an den Schwingkreiskondensator angeschlossen oder über eine zusätzliche Wicklung angekoppelt wird. Im letzteren Fall besteht der Vorteil der freien Wahl des Bezugspotentials für die Kapazitätsdioden-Steuerspannung. Zusätzlich kann durch Wahl der Windungsverhältnisse der zusätzlichen Wicklung zur Schwingkreiswicklung, die für den Schwingkreis effektive Kapazität festgelegt werden, wodurch die verwendete Kapazitätsdiode optimal angepasst und ausgenutzt werden kann.

Dies erlaubt einen einfacheren Massebezug für die Kapazitätsdiode und durch die frei wählbare Anzahl der Windungen eine optimale Anpassung an den Kapazitätsbereich. Weiterhin kann ein Verstärkungselement zum Verstärken des Ausgangssignals des Oszillators vorgesehen sein. Dies ermöglicht eine Ausgabe eines Ausgangssignals über eine Leitung bei gleichzeitig niedriger kapazitiver Belastung des Schwingkreises. Im einfachsten Fall kann hier ein Transistor in Spannungsfolger-Schaltung verwendet werden.

Um externe Störungen sowie Störungen durch den Ausgangsverstärker vom Oszillator fernzuhalten, können zwei Filter vorgesehen sein. Diese verhindern weiterhin ein Weiterleiten der hochfrequenten Störungen, die vom Oszillator verursacht werden können, in die Zuleitung.

Für eine optimale Funktion der Schaltung, auch bei Sensorkapazitäten im Picofarad-Bereich bestehen besondere Anforderungen an die Spule. Da bei kleinen Sensorkapazitäten hohe Oszillatorfrequenzen bestehen, ist es bevorzugt, dass das Kernmaterial der Spule derart gewählt ist, dass es niedrige Ummagnetisierungsverluste aufweist (z.B. K1 von EPCOS).

Da die Spule als Schwingkreisinduktivität eingesetzt wird, muss sie die Fähigkeit besitzen, Energie zu speichern. Dabei weist die Induktivität bevorzugt einen Luftspalt zum Speichern magnetischer Energie auf. Dieser kann über den Kern verteilt sein, vorzugsweise wird er aber als diskreter Spalt im magnetischen Pfad ausgeführt.

Ein Material mit hoher Permeabilität ist zwar gut geeignet um magnetische Feldlinien zu konzentrieren, wie beispielsweise in einem Ferritkern. Jedoch würde aufgrund der dann sehr starken Hysterese der Magnetisierung die einer mit einem solchen Kern aufgebauten Spule zugeführte Energie nur zur Ummagnetisierung des Kernmaterials verwendet und könnte nur zu einem geringen Teil wieder entnommen werden. Dies hätte eine schlechte Güte zur Folge. Reine Luftspulen weisen diese Hysterese nicht auf, da kein Material ummagnetisiert werden muss. Allerdings haben sie ein großes Streufeld und bei gleicher Menge enthaltenem Leitermaterial nur eine deutlich geringe Induktivität. In der Praxis wählt man daher für Spulen, die Energie speichern sollen, wie beispielsweise Spulen für Schwingkreise, meistens einen Kompromiss und versieht einen hochpermeablen Kern mit einem Luftspalt. Dadurch bleibt die gute Konzentration der magnetischen Feldlinien erhalten, während die Hysterese deutlich verkleinert wird, so dass die Güte einer Spule mit Luftspalt bereits deutlich besser ist als ohne. Die resultierende, etwas niedrigere Gesamtpermeabilität der Spule muss jedoch mit mehr Leitermaterial kompensiert werden. Spezielle Ferritpulvermaterialien sind bereits von der Materialstruktur her mit vielen kleinen, über den Kern verteilten "Luftspalten" ausgestattet, so dass dann kein dedizierter Spalt erforderlich ist.

Da die parasitäre Wicklungskapazität zur effektiven Schwingkreiskapazität beiträgt, sollte sie möglichst gering gehalten werden. Gleichzeitig muss die Oszillatorfrequenz ebenfalls möglichst gering gehalten werden, um die Störabstrahlung durch die Sensorplatten zu minimieren. Um eine geringe parasitäre Wicklungskapazität zu erreichen, wird somit eine niedrige Windungszahl gewählt. Um trotz dieser niedrigen Windungszahl eine möglichst hohe Induktivität der Spule zu erreichen, ist es bevorzugt, dass die Induktivität einen Schalenkern aufweist. Besonders bevorzugt ist es dabei, dass der Luftspalt im Inneren des Kerns liegt und damit magnetische Streufelder außerhalb des Kerns minimiert werden.

Da die Spule als Transformator verwendet wird, muss trotz des Luftspaltes eine sehr gute magnetische Koppelung zwischen der Primärwicklung und der Sekundärwicklung sichergestellt werden. Dies kann insbesondere dadurch erreicht werden, dass die Primärwicklung und die Sekundärwicklung auf den gleichen Spulenkörper gewickelt sind.

Die genannten Merkmale ermöglichen somit eine einfach aufgebaute Schaltung, die zur Ansteuerung des kapazitiven Sensors ein oder zwei Transistoren sowie gegebenenfalls eine Kapazitätsdiode als aktive Bauteile aufweist. Weiterhin sind nur wenige passive Bauteile notwendig, was sowohl einen Aufbau unter beengten Platzverhältnissen ermöglicht als auch einen strahlenfesten Aufbau erleichtert.

In einer bevorzugten Ausführungsform weist das Sensormodul einen Schaltabstand von mehr als 1 mm auf, so dass es möglich ist, eine Verriegelung durch die Verriegelungsvorrichtung vorzunehmen, bevor die Wartungsvorrichtung nach einem Anstoßen an die Satelliten wieder aus der möglichen Verriegelungsposition gedriftet ist. Ein eventuelles Wegdriften des Satelliten oder der Wartungsvorrichtung kann so verhindert werden. Da beim Eindringen der Andockvorrichtung in die Düse mit sehr geringen Kräften gearbeitet wird, ist es wichtig, ein berührungsloses Messsystem zu verwenden. Ebenso bietet der beschriebene Sensor die Möglichkeit, den durch eine weiterverarbeitende Elektronik bestimmten Schaltabstand einzustellen und somit eine nachträgliche Anpassung an verschiedenen Düsenkonturen vorzunehmen. Eine Anpassung an verschiedene Düsenkonturen kann alternativ oder zusätzlich dazu auch durch ein Verstellen des Neigungswinkels der verwendeten kapazitiven Sensormodule erfolgen. Bei dem Neigungswinkel handelt es sich um den Winkel zwischen der Mantelfläche der Haltevorrichtung und der Grundfläche der Haltevorrichtung.

Im folgenden werden bevorzugte Ausführungsformen der Erfindung anhand von Figuren erläutert. Es zeigen:
- Fig. 1: eine schematische Ansicht einer erfindungsgemäßen Andockvorrichtung in der Düse eines Satelliten,
- Fig. 2: eine schematische Ansicht eines Abstandssensors,
- Fig. 3: eine schematische Ansicht eines kapazitiven Sensormoduls,
- Fig.4: ein Schaltbild eines beispielhaften Aufbaus der erfindungsgemäßen Oszillatorschaltung.

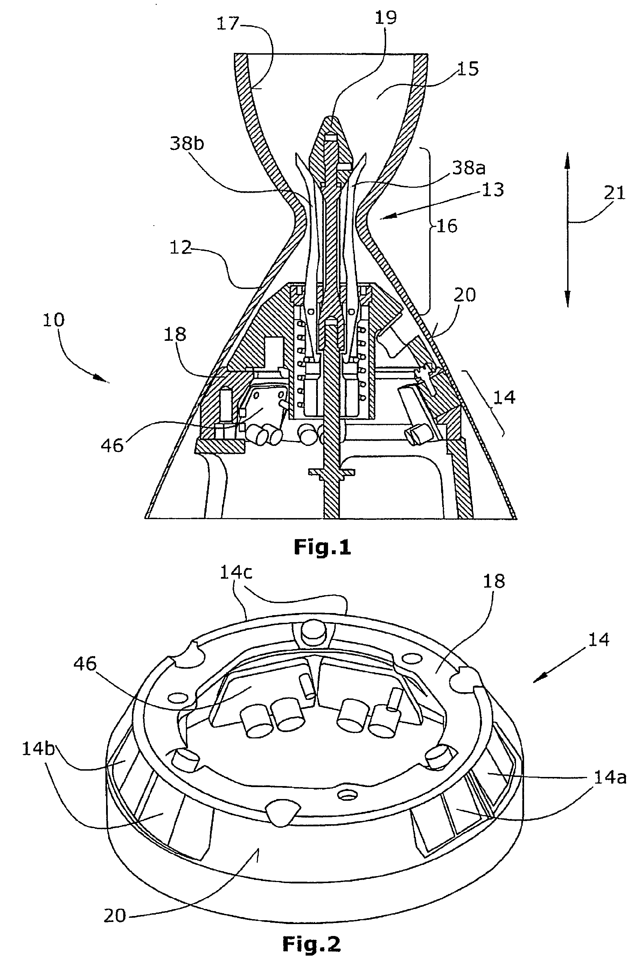

Gemäß Fig. 1 weist eine Andockvorrichtung 10 zum Andocken einer nicht dargestellten Wartungsvorrichtung an eine Düse 12 eines Satelliten einen Abstandssensor 14 zum Bestimmen des Abstandes zwischen der Wartungsvorrichtung und der Düse 12 des Satelliten auf. Weiterhin ist eine Verriegelungsvorrichtung 16 zum Verbinden der Andockvorrichtung 10 mit der Düse 12 des Satelliten vorgesehen.

Vorzugsweise ist die Verriegelungsvorrichtung derart ausgestaltet, dass sie eine Verriegelung der Andockvorrichtung an einer Engstelle 13 der Düse 12 des Satelliten ermöglicht. Hierzu kann die Verriegelungsvorrichtung 16 beispielsweise zwei Verriegelungsarme 38a,38b zum Hintergreifen der Engstelle 13 der Düse 12 aufweisen. Weiterhin kann eine Aufspreizvorrichtung 15 zum Aufspreizen der Verriegelungsarme 38a,38b vorgesehen sein. Vorzugsweise ist die Aufspreizvorrichtung 15 zwischen den Verriegelungsarmen 38a,38b angebracht. Besonders vorteilhaft ist, dass die Verriegelungsarme 38a,38b an ihrem von der Andockvorrichtung 10 wegweisenden Ende nach außen, d.h. in Richtung der Innenwand 17 der Düse 12, insbesondere von der Aufspreizvorrichtung 15 weg verlaufen. Die Verriegelungsarme 38a,38b können dabei gebogen und/oder geknickt sein.

Zum Aufspreizen der Verriegelungsarme 38a,38b kann die Aufspreizvorrichtung 15 an ihrem von der Andockvorrichtung 10 wegweisenden Ende eine Verdickung 19 aufweisen. Ein Aufspreizen der Verriegelungsarme 38a,38b kann dabei durch ein Verschieben der Aufspreizvorrichtung 15 in axialer Richtung 21 der Andockvorrichtung 10 erfolgen. Dadurch wird gleichzeitig die Verdickung 19 der Aufspreizvorrichtung 15 verschoben, so dass durch die Verdickung 19 ein Aufspreizen der Verriegelungsarme 38a,38b verursacht wird.

Der Abstandssensor 14 ist als kapazitiver Abstandssensor ausgebildet, der drei kapazitive Sensormodule 14a,14b,14c aufweist, die in gleichmäßigen Abständen an der Außenseite einer ringförmigen Haltevorrichtung 18 angebracht sind (siehe Fig. 2). Die Haltevorrichtung 18 ist als kreisringförmiger Kegelstumpf ausgebildet, wobei die Sensormodule 14a,14b,14c an der Außenseite der Mantelfläche 20 des ringförmigen Kegelstumpfes 18 in einem spitzen Winkel zur Grundfläche des Kegelstumpfes angeordnet sind. Zur Anpassung an verschiedene Düsengeometrien kann dieser Winkel veränderbar sein.

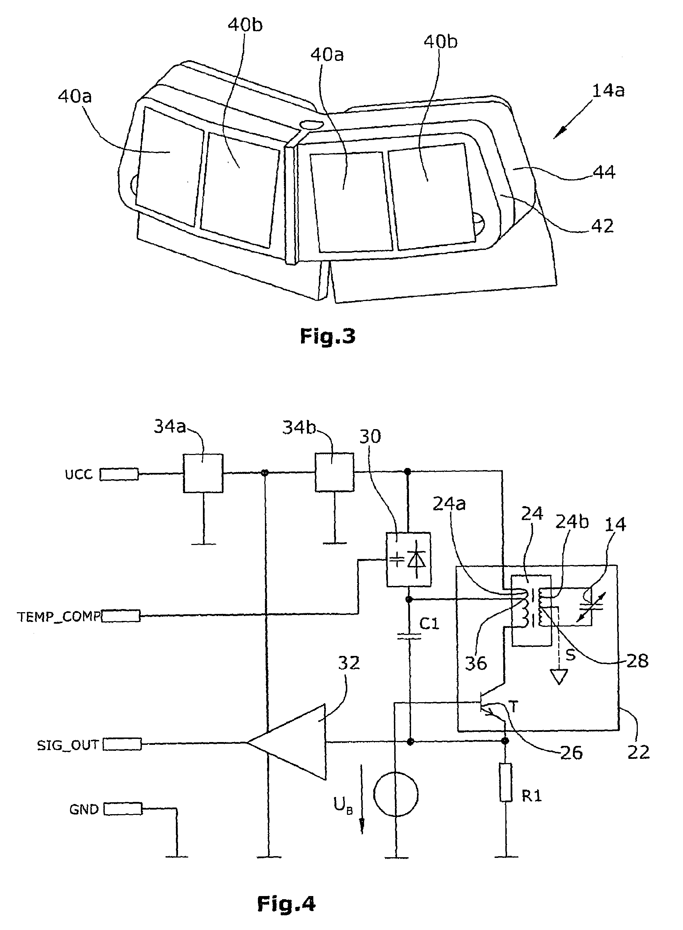

Fig. 3 zeigt schematisch den mechanischen Aufbau eines Sensormoduls 14a. Zur Abstandsmessung gegen eines metallisches Objekt, beispielsweise die Düse 12, werden zwei nebeneinander liegende Kondensatorplatten 40a,40b verwendet, die auf einem Isolierkörper 42 aufgebracht sind und mit einer isolierenden Schicht überzogen sind. Um einen redundanten Sensoraufbau zu ermöglichen und trotzdem die begrenzten Platzverhältnisse optimal nutzen zu können, werden zwei Paare von nebeneinander liegenden Kondensatorplatten 40a,40b zu einem Sensormodul 14a kombiniert. Ein Sensormodul 14a weist somit eine oder mehrere Sensorflächen auf, welche jeweils die beiden metallischen Kondensatorplatten 40a,40b tragen und jeweils auf einem Isolierkörper 42 sitzen. Sowohl die Sensorflächen als auch die Kondensatorplatten 40a,40b können in einem Winkel zueinander angeordnet sein, so dass eine Anpassung an die kreisringförmige Ausbildung der Haltevorrichtung vereinfacht wird. Der Isolierkörper 42 ist auf einem metallischen Träger 44 angebracht, auf dessen Rückseite, d.h. in Richtung des Innenraums der ringförmigen Haltevorrichtung 18, direkt ein oder zwei Platinen 46 mit der Auswerteelektronik sitzen.

Bevorzugt werden mindestens drei der Sensormodule 14a,14b,14c in einer ringförmigen Haltevorrichtung 18 zusammengefasst, die als Kegelstumpf ausgebildet ist. Die Schräge des Kegelstumpfs ist derart gewählt, dass sie dem Mittelwert der Schräge der anzudockenden Düsen 12 an der Stelle entspricht, an der die Verriegelung erfolgt.

Durch die kompakte Anordnung sind sowohl eine gute thermische Kopplung zwischen den Komponenten - wichtig für die Temperaturkompensation - als auch störungsarme elektrische Signale sichergestellt. Auch enthält dieser Ring vorzugsweise den oder die Temperatursensor(en), welche das für eine Kompensation erforderliche Temperatursignal liefern.

Die Sensormodule 14a,14b,14c können einzeln aufgebaut und getestet werden, bevor sie in die Haltevorrichtung 18 integriert werden. Nach dem Einpassen werden die Sensormodule 14a,14b,14c vorzugsweise vergossen. Die so entstehende Isolationsschicht über den Kondensatorplatten 40a,40b ist dabei bevorzugt mindestens 1 mm stark und schützt in ausreichendem Maße vor elektrostatischer Entladung.

Für eine Detektion der optimalen Verriegelungsposition in der Düse sind vorzugsweise drei um 120° versetzte Sensormodule 14a,14b,14c vorgesehen. Eine Verriegelung kann ausgelöst werden, wenn alle drei Sensormodule 14a,14b,14c den geforderten Abstand detektieren. Bei geforderter Redundanz wird die beschriebene doppelte Ausführung gewählt, bei der nur die nominale oder die redundante Einheit aktiv sein muss. Alternativ ist es auch möglich, die optimale Verriegelungsposition durch zwei gegenüberliegende Sensormodule 14a,14b zu erfassen. Durch den beschriebenen Aufbau kann sichergestellt werden, dass ein Verriegeln der Verriegelungsvorrichtung 16 hinter der Engstelle 13 der Düse 12 stattfindet und der Zielsatellit sicher gegriffen werden kann.

Ein möglicher Aufbau einer Oszillatorschaltung wird im folgenden anhand von Fig. 4 näher erläutert. Die hier beschriebene Ausführungsform stellt lediglich ein kapazitives Sensormodul 14a dar, wobei entsprechend den bisher beschriebenen Ausführungsformen auch mehrere kapazitive Sensormodule 14a,14b,14c verwendet werden können. Dabei kann jedes Sensormodul 14a,14b,14c seine eigene Auswerteelektronik aufweisen.

Es ist ein Oszillator 22 vorgesehen, der einen kapazitiven Abstandssensor 14 sowie eine Induktivität 24 aufweist, die zu einem elektrischen Schwingkreis verschaltet sind. Weiterhin ist eine Energiezuführvorrichtung 26 in Form eines Transistors zum Zuführen elektrischer Energie an den elektrischen Schwingkreis vorgesehen. Die Induktivität 24 weist eine Primärwicklung 24a sowie eine Sekundärwicklung 24b auf, die auf den gleichen Spulenkörper gewickelt sind. Dabei weist die Sekundärwicklung 24b mehr Windungen auf als die Primärwicklung 24a. Das kapazitive Sensormodul 14a ist über die Primärwicklung 24a und die Sekundärwicklung 24b transformatorisch in den Oszillator 22 eingebunden. Der Oszillator ist als Hartley-Oszillator ausgebildet. Die Frequenz des Oszillators hängt von der Kapazität des kapazitiven Abstandssensors 14 ab. Dessen Kapazität hängt wiederum von seinem Abstand zur Innenwand 17 der Düse 12 ab.

Der Transistor 26 kann als Bipotar-Transistor oder als J-Fet-Transistor ausgebildet sein. Eine Vorspannung U_{B} ist für den Einsatz von bipolaren Transistoren erforderlich, bei J-Fets liegt sie, da diese selbstleitend sind, üblicherweise bei 0.

Vorzugsweise ist eine Kapazitätsdiode 30 vorgesehen, um durch eine von außen zugeführte temperaturabhängige Spannung eine zusätzliche Verstimmung des Oszillators 22 zu erreichen und damit einen Temperaturdrift zu kompensieren.

Weiterhin kann ein Verstärkerelement in Form eines Transistors in Spannungsfolger-Schaltung 32 zum Ausgeben eines Ausgangssignals vorgesehen sein. Ferner kann die Schaltung zwei Filter 34a,34b aufweisen.

Die Induktivität 24 wird als Transformator verwendet. Daher muss trotz des zur Speicherung magnetischer Energie vorgesehenen Luftspaltes eine sehr gute magnetische Kopplung zwischen der Primärwicklung 24a und der Sekundärwicklung 24b sichergestellt werden. Dies kann durch einen Wicklungsaufbau auf einem einteiligen Spulenkörper erreicht werden. Die erste Lage besteht vorzugsweise aus der ersten Hälfte der Sekundärwicklung (beispielsweise 20 Windungen) bis zu einem optionalen Mittelabgriff und wird möglichst einlagig gewickelt, um die Wicklungskapazität klein zu halten. Darüber kommt, je nach Anforderungen an die Isolationsspannung, gegebenenfalls eine zusätzliche Isolationsschicht. Darauf erfolgt eine optionale Schirmlage, welche aus Metallfolie besteht und elektrisch an der Schaltungs- oder der Gehäusemasse angekoppelt ist. Auch hier kann eine zusätzliche Isolation erforderlich sein. In der Mitte des Lagenaufbaus liegt vorzugsweise die Primärwicklung (beispielsweise 4 oder 5 Windungen) mit einem Abgriff nach wenigen Windungen (beispielsweise 1 oder 2 Windungen) für die Erregung des Hartley-Oszillators und gegebenenfalls die separate Wicklung für die Temperaturkompensation (1 oder 2 Windungen). Eine Temperaturkompensation kann durch Messung der Temperatur und Ansteuerung einer Kapazitätsdiode mit einem aus der Temperatur gewonnenen Signal erfolgen. Die Kapazitätsdiode kann dabei mit an der Hauptwicklung oder dem Angriff zur Anregung über Mitkopplung des Schwingkreises bzw. an einer separaten Wicklung angeschlossen sein.

Gegebenenfalls folgt eine weitere Isolationslage. Vorzugsweise folgt eine weitere Schirmlage mit einer optionalen Isolation. Zu oberst liegt vorzugsweise die zweite Hälfte der Sekundärwicklung (beispielsweise 20 Windungen), insbesondere mit einer Isolationsschicht darauf.

## Patentansprüche

1. Andockvorrichtung zum Andocken einer Wartungsvorrichtung an eine Düse (12) eines Satelliten, mit
einem Abstandssensor (14) zum Bestimmen des Abstandes zwischen der Wartungsvorrichtung und der Düse (12) des Satelliten, und
einer Verriegelungsvorrichtung (16) zum Verbinden der Andockvorrichtung (10) mit der Düse (12) des Satelliten,
**dadurch gekennzeichnet,**
**dass** der Abstandssensor (14) als kapazitiver Abstandssensor ausgebildet ist.

2. Andockvorrichtung nach Anspruch 1, **dadurch gekennzeichnet, dass** der kapazitive Abstandssensor (14) mehrere, insbesondere drei kapazitive Sensormodule (14a, 14b, 14c) aufweist.

3. Andockvorrichtung nach Anspruch 2, **dadurch gekennzeichnet, dass** die kapazitiven Sensormodule (14a, 14b, 14c) insbesondere in gleichmäßigen Abständen an der Außenseite einer ringförmigen Haltvorrichtung (18) angebracht sind und die ringförmige Haltevorrichtung (18) insbesondere als ringförmiger Kegelstumpf ausgebildet ist.

4. Andockvorrichtung nach Anspruch 3, **dadurch gekennzeichnet, dass** die Sensormodule (14a, 14b, 14c) an der Außenseite der Mantelfläche (20) des ringförmigen Kegelstumpfes (18) insbesondere in einem spitzen Winkel zur Grundfläche des Kegelstumpfes (18) angeordnet sind.

5. Andockvorrichtung nach einem der Ansprüche 1 bis 4, **dadurch gekennzeichnet, dass** der kapazitive Abstandssensor (14) einen Oszillator und insbesondere einen Hartley-Oszillator (22) aufweist, wobei der Oszillator (22) aufweist:
eine kapazitives Sensormodul (14a) und eine Induktivität (24), die zu einem elektrischen Schwingkreis verschaltet sind, und
eine Energiezuführvorrichtung (26) zum Zuführen elektrischer Energie an den elektrischen Schwingkreis,
wobei die Induktivität (24) insbesondere eine Primärwicklung (24a) und eine Sekundärwicklung (24b) aufweist und das kapazitive Sensormodul (14a) über die Primärwicklung (24a) und die Sekundärwicklung (24b) transformatorisch in den Oszillator (22) eingebunden ist.

6. Andockvorrichtung nach Anspruch 5, **dadurch gekennzeichnet, dass** die Sekundärwicklung (24b) einen Mittelabgriff (28) aufweist, der mit einem Masse-Anschluss verbunden ist, wobei die Sekundärwicklung (24b) insbesondere mehr Windungen aufweist als die Primärwicklung (24a).

7. Andockvorrichtung nach einem der Ansprüche 5 oder 6, **dadurch gekennzeichnet, dass** der Oszillator (22) mit einer Kapazitätsdiode (30) zur Abstimmung des Oszillators (22) verbunden ist und dem Oszillator (22) über die Kapazitätsdiode (30) insbesondere eine temperaturabhängige Spannung zuführbar ist.

8. Andockvorrichtung nach einem der Ansprüche 5 bis 7, **gekennzeichnet durch** ein Verstärkungselement (32) zum Verstärken des Ausgangsignals des Oszillators, wobei das Verstärkungselement (32) insbesondere als Transistor oder als Transistor in Spannungsfolger-Schaltung ausgebildet ist.

9. Andockvorrichtung nach einem der Ansprüche 5 bis 8, **dadurch gekennzeichnet, dass** die Energiezuführvorrichtung (26) als Transistor ausgebildet ist und der Oszillator (22) insbesondere mit mindestens einer Filtervorrichtung (34a, 34b) verbunden ist.

10. Andockvorrichtung nach einem der Ansprüche 5 bis 9, **dadurch gekennzeichnet, dass** die Induktivität (24) ein Kernmaterial mit niedrigen Ummagnetisierungsverlusten aufweist, das für den Hochfrequenzbereich geeignet ist, die Induktivität (24) insbesondere einen Luftspalt zum Speichern magnetischer Energie aufweist und die Induktivität (24) insbesondere einen Schalenkern aufweist, wobei der Luftspalt im Inneren des Schalenkerns angeordnet ist.

11. Andockvorrichtung nach einem der Ansprüche 5 bis 10, **dadurch gekennzeichnet, dass** die Primärwicklung (24a) und die Sekundärwicklung (24b) auf den gleichen Spulenkörper gewickelt sind und die Primärwicklung (24a) insbesondere einen Abgriff oder einen Mittelabgriff (32), für die Erregung des Oszillators (22) aufweist.

12. Andockvorrichtung nach einem der Ansprüche 1 bis 11, **dadurch gekennzeichnet, dass** der Schaltabstand des kapazitiven Abstandssensors (14) einstellbar ist.

13. Andockvorrichtung nach einem der Ansprüche 1 bis 12, **dadurch gekennzeichnet, dass** die Verriegelungsvorrichtung (16) Verriegelungsarme (38a,38b) zum Hintergreifen einer Engstelle (13) der Düse (12) aufweist, wobei die Verriegelungsvorrichtung (16) eine Aufspreizvorrichtung (15) zum Aufspreizen der Verriegelungsarme (38a,38b) aufweist, dass die Aufspreizvorrichtung (15) insbesondere zwischen den Verriegelungsarmen (38a,38b) angebracht ist und die Verriegelungsarme (38a,38b) an ihrem von der Andockvorrichtung (10) wegweisenden Ende nach außen, d.h. in Richtung der Innenwand (17) der Düse (12) insbesondere von der Aufspreizvorrichtung (15) weg gebogen und/oder geknickt sind.

14. Andockvorrichtung nach Anspruch 13, **dadurch gekennzeichnet, dass** die Aufspreizvorrichtung (15) an ihrem von der Andockvorrichtung (10) wegweisenden Ende eine Verdickung (19) zum Aufspreizen der Verriegelungsarme (38a,38b) aufweist.

15. Andockvorrichtung nach Anspruch 14, **dadurch gekennzeichnet, dass** die Aufspreizvorrichtung (15) in axialer Richtung (21) der Andockvorrichtung (10) derart verschiebbar ist, dass durch ein Verschieben der Aufspreizvorrichtung (15) zur Andockvorrichtung (10) hin ein durch die Verdickung (19) verursachtes Aufspreizen der Verriegelungsarme (38a,38b) erfolgt.

## Claims

1. Docking device for the docking of a maintenance device to a nozzle (12) of a satellite, comprising
a distance sensor (14) for determining the distance between the maintenance device and the nozzle (12) of the satellite, and
a locking device (16) for connecting the docking device (10) with the nozzle (12) of the satellite,
**characterized in that**
the distance sensor (14) is designed as a capacitive distance sensor.

2. Docking device of claim 1, **characterized in that** the capacitive distance sensor (14) comprises a plurality, in particular three capacitive sensor modules (14a, 14b, 14c).

3. Docking device of claim 2, **characterized in that** the capacitive sensor modules (14a, 14b, 14c) are mounted in particular equidistantly on the outer side of an annular holding device (18) and that the annular holding device (18) is designed as an annular truncated cone.

4. Docking device of claim 3, **characterized in that** the sensor modules (14a, 14b, 14c) are arranged on the outer side of the shell surface (20) of the annular truncated cone (18) in particular under an acute angle with respect to the base surface of the truncated cone (18).

5. Docking device of one of claims 1 to 4, **characterized in that** the capacitive distance sensor (14) comprises an oscillator and in particular a Hartley oscillator (22), said oscillator (22) comprising:
a capacitive sensor module (14a) and an inductor (24) connected to form an electric oscillating circuit, and
an energy supply device (26) for supplying electric energy to the electric oscillating circuit,
wherein the inductor (24) specifically has a primary winding (24a) and a secondary winding (24b) and the capacitive sensor module (14a) is integrated into the oscillator (22) in a transformer-like manner via the primary winding (24a) and the secondary winding (24b).

6. Docking device of one of claim 5, **characterized in that** the secondary winding (24b) has a central tap (28) connected to a ground terminal, wherein the secondary winding (24b) comprises more turns than the primary winding (24a).

7. Docking device of one of claims 5 or 6, **characterized in that** the oscillator (22) is connected with a capacitance diode (30) for tuning the oscillator. (22), and that the oscillator (22) can be fed a temperature-dependent voltage via the capacitance diode (30).

8. Docking device of one of claims 5 to 7, **characterized by** an amplifier element (32) for an amplification of the output signal of the oscillator, wherein the amplifier element (32) is configured in particular as a transistor or as a transistor in a voltage follower connection.

9. Docking device of one of claims 5 to 8, **characterized in that** the energy supply device (26) is configured as a transistor and that the oscillator (22) is connected in particular with at least one filter device (34a, 34b).

10. Docking device of one of claims 5 to 9, **characterized in that** the inductor (24) comprises a core material with low magnetic reversal losses that is suited for use in the high frequency range, that the inductor (24) comprises an air gap for storing magnetic energy, and that the inductor (24) comprises a pot core, the air gap being provided within the pot core.

11. Docking device of one of claims 5 to 10, **characterized in that** the primary winding (24a) and the secondary winding (24b) are wound on the same coil body and that the primary winding (24a) comprises in particular a tap or a central tap (32) for exciting the oscillator (22).

12. Docking device of one of claims 1 to 11, **characterized in that** the sensing distance of the capacitive distance sensor (14) is adjustable.

13. Docking device of one of claims 1 to 12, **characterized in that** the locking device (16) comprises locking arms (38a, 38b) for engaging behind a constriction (13) of the nozzle (12), wherein the locking device (16) comprises a spreading device (15) for spreading the locking arms (38a, 38b), that the spreading device (15) is provided in particular between the locking arms (38a, 38b) and that, at their ends averted from the docking device (10), the locking arms (38a, 38b) are bent and/or kinked outward, i.e. towards the inner wall (17) of the nozzle (12), in particular away from the spreading device (15).

14. Docking device of claim 13, **characterized in that** the spreading device (15) has an enlargement (19) at its end averted from the docking device (10), the enlargement serving to spread the locking arms (38a, 38b).

15. Docking device of claim 14, **characterized in that** the spreading device (15) is displaceable in the axial direction (21) of the docking device (10) such that by a displacement of the spreading device (15) towards the docking device (10), a spreading of the locking arms (38a, 38b) is effected that is caused by the enlargement (19).

## Revendications

1. Dispositif d'amarrage pour l'amarrage d'un dispositif de maintenance à une buse (12) d'un satellite, comprenant
un détecteur de distance (14) pour déterminer la distance entre le dispositif de maintenance et ladite buse (12) dudit satellite, et
un dispositif de verrouillage (16) pour connecter ledit dispositif d'amarrage (10) à ladite buse (12) du satellite,
**caractérisé en ce que**
ledit détecteur de distance (14) est configuré comme un détecteur de distance capacitif.

2. Dispositif d'amarrage selon la revendication 1, **caractérisé en ce que** ledit détecteur de distance capacitif (14) comprend plusieurs, notamment trois modules de détecteurs capacitifs (14a, 14b, 14c).

3. Dispositif d'amarrage selon la revendication 2, **caractérisé en ce que** lesdits modules de détecteurs capacitifs (14a, 14b, 14c) sont prévus notamment à distances égales sur l'extérieur d'un dispositif de retenue (18) annulaire, et que ledit dispositif de retenue (18) annulaire est configuré en particulier comme un tronc de cône annulaire.

4. Dispositif d'amarrage selon la revendication 3, **caractérisé en ce que** les modules de détecteurs (14a, 14b, 14c) sont disposés sur l'extérieur de la surface de l'enveloppe dudit tronc de cône annulaire (18), notamment sous un angle aigu par rapport à la surface de base dudit tronc de cône (18).

5. Dispositif d'amarrage selon l'une quelconque des revendications 1 à 4, **caractérisé en ce que** ledit détecteur de distance capacitif (14) comprend un oscillateur et notamment un oscillateur Hartley (22), ledit oscillateur (22) comprenant:
un module de détecteur capacitif (14a) et une inductance (24) connecté pour former un circuit oscillant électrique, et
un dispositif d'alimentation en énergie (26) pour fournir de l'énergie électrique audit circuit oscillant électrique,
ladite inductance (24) comprenant en particulier un enroulement primaire (24a) et un enroulement secondaire (24b), et ledit module de détecteur capacitif (14a) étant intégré de manière transformatrice dans ledit oscillateur (22) à travers ledit enroulement primaire (24a) et ledit enroulement secondaire (24b).

6. Dispositif d'amarrage selon la revendication 5, **caractérisé en ce que** ledit enroulement secondaire (24b) comprend une prise intermédiaire (28) connectée à une borne de masse, ledit enroulement secondaire (24b) comprenant en particulier plus de tours que ledit enroulement primaire (24a).

7. Dispositif d'amarrage selon les revendications 5 ou 6, **caractérisé en ce que** l'oscillateur (22) est connecté à une diode de capacité (30) pout syntoniser ledit oscillateur (22), et qu'un voltage, notamment un voltage dépendant de la température, peut être fourni audit oscillateur (22) à travers ladite diode de capacité (30).

8. Dispositif d'amarrage selon l'une quelconque des revendications 5 à 7, **caractérisé par** un élément amplificateur (32) pour amplifier le signal de sortie dudit oscillateur, ledit élément amplificateur (32) étant configuré en particulier comme un transistor ou comme un transistor en étage suiveur.

9. Dispositif d'amarrage selon l'une quelconque des revendications 5 à 8, **caractérisé en ce que** le dispositif d'alimentation en énergie (26) est configuré comme un transistor et ledit oscillateur (22) est connecté en particulier à un dispositif de filtre (34a, 34b).

10. Dispositif d'amarrage selon l'une quelconque des revendications 5 à 9, **caractérisé en ce que** ladite inductance (24) comprend un matériau de noyau avec peu de perte par inversion magnétique, apte à être utilisé dans la domaine de radiofréquence, que ladite inductance (24) comprend en particulier une discontinuité magnétique pour accumuler de l'énergie magnétique, et que ladite inductance (24) comprend en particulier un noyau en pot, ladite discontinuité magnétique étant disposée à l'intérieur dudit noyau en pot.

11. Dispositif d'amarrage selon l'une quelconque des revendications 5 à 10, **caractérisé en ce que** l'enroulement primaire (24a) et l'enroulement secondaire (24b) sont enroulés sur le même corps de bobine, et que ledit enroulement primaire (24a) comprend en particulier une prise ou une prise intermédiaire (32) servant à exciter ledit oscillateur (22).

12. Dispositif d'amarrage selon l'une quelconque des revendications 1 à 11, **caractérisé en ce que** l'intervalle de commutation dudit détecteur de distance capacitif (14) est réglable.

13. Dispositif d'amarrage selon l'une quelconque des revendications 1 à 12, **caractérisé en ce que** ledit dispositif de verrouillage (16) comprend des bras de verrouillage (38a, 38b) pour engager derrière une partie étroite (13) de la buse (12), ledit dispositif de verrouillage (16) comprenant un dispositif écarteur (15) pour déployer lesdits bras de verrouillage (38a, 38b), que ledit dispositif écarteur (15) est disposé en particulier entre lesdits bras de verrouillage (38a, 38b) et les extrémités desdits bras de verrouillage (38a, 38b), tournées dans la direction opposée au dispositif d'amarrage (10), sont courbées et/ou pliées vers l'extérieur, c'est à dire vers le parois intérieur (17) de la buse (12), en particulier dans la direction opposée au dispositif écarteur (15).

14. Dispositif d'amarrage selon la revendication 13, **caractérisé en ce que** ledit dispositif écarteur (15) comprend un renflement (19) à son extrémité tournée dans la direction opposée au dispositif d'amarrage (10), le renflement servant à déployer les bras de verrouillage (38a, 38b).

15. Dispositif d'amarrage selon la revendication 14, **caractérisé en ce que** ledit dispositif écarteur (15) est déplaçable dans la direction axiale (21) dudit dispositif d'amarrage (10) de manière qu'un déplacement dudit dispositif écarteur (15) vers le dispositif d'amarrage (10) fait déployer les bras de verrouillage (38a, 38b) sous l'effet du renflement (19).
